# DEMANDE DE BREVET EUROPEEN

(11) **EP 2 669 939 A1**
(43) Date de publication de la demande: **04.12.2013**
(21) Numéro de dépôt: 13169638.7
(22) Date de dépôt: 29.05.2013
(51) Int. Cl.: H01L 21/84, H01L 27/12, H01L 21/762

(54) **Procédé de fabrication d'un circuit intégré ayant des tranchées d'isolation avec des profondeurs distinctes**

(30) Priorité: 29.05.2012 FR 1254933
(71) Demandeur: Commissariat à l'Énergie Atomique et aux Énergies Alternatives, 75015 Paris (FR); STMicroelectronics (Crolles 2) SAS, 38920 Crolles (FR)
(72) Inventeur: Fenouillet-Beranger, Claire, 38000 GRENOBLE (FR); Denorme, Stéphane, 38920 CROLLES (FR)
(74) Mandataire: Guérin, Jean-Philippe

(57) **Abrégé**

L'invention propose un procédé de fabrication d'un circuit intégré, comprenant les étapes de :
-dans un empilement de couches incluant un substrat de silicium (101) surplombé par une couche d'isolant enterré (102) surplombée par une couche de silicium (103), graver des premières gorges ;
-déposer une couche de nitrure de silicium (106) surplombant la couche de silicium de façon à remplir lesdites premières gorges et former des premières tranchées d'isolation;
-former un masque surplombant la couche de nitrure de silicium;
-graver des secondes gorges (22) à une profondeur supérieure à la profondeur des premières gorges;
-remplir les secondes gorges par un matériau isolant électrique pour former des deuxièmes tranchées d'isolation;
-réaliser une attaque chimique jusqu'à découvrir la couche de silicium (103) ;
-former des transistors FET en formant le canal, la source et le drain de ces transistors dans la couche de silicium (103).

## Description

L'invention concerne les circuits intégrés, et en particulier les circuits intégrés réalisés sur un substrat de type silicium sur isolant (SOI). La technologie SOI consiste à séparer une fine couche de silicium (quelques nanomètres) sur un substrat en silicium par une couche d'isolant relativement épaisse (quelques dizaines de nanomètres en règle générale).

Les circuits intégrés réalisés en technologie SOI présentent un certain nombre d'avantages. De tels circuits présentent généralement une plus faible consommation électrique pour des performances équivalentes. De tels circuits induisent également des capacités parasites plus faibles, qui permettent d'améliorer la vitesse de commutation. De plus, le phénomène de déclenchement parasite (latchup en langue anglaise) rencontré par les transistors MOS en technologie Bulk peut être évité. De tels circuits s'avèrent donc particulièrement adaptés pour des applications de type SoC ou MEMS. On constate également que les circuits intégrés SOI sont moins sensibles aux effets des radiations ionisantes et s'avèrent ainsi plus fiables dans des applications où de telles radiations peuvent induire des problèmes de fonctionnement, notamment dans des applications spatiales. Les circuits intégrés SOI peuvent notamment comprendre des mémoires vives de type SRAM ou des portes logiques.

La réduction de la consommation statique de portes logiques tout en augmentant leur vitesse de basculement fait l'objet de nombreuses recherches. Certains circuits intégrés en cours de développement intègrent à la fois des portes logiques à faible consommation et des portes logiques à vitesse de basculement élevée. Pour générer ces deux types de portes logiques sur un même circuit intégré, on rabaisse la tension de seuil de certains transistors des portes logiques à accès rapide, et on augmente la tension seuil d'autres transistors des portes logiques à faible consommation. En technologie Bulk, la modulation du niveau de tension de seuil de transistors de même type est effectuée en différenciant le niveau de dopage de leur canal ainsi qu'en modulant la tension appliquée sur le caisson. Cependant, en technologie FDSOI (pour Fully Depleted Silicium On Insulator en langue anglaise, désignant du silicium totalement déserté sur isolant), le dopage du canal est quasiment nul (10¹⁵ cm⁻³). Ainsi, le niveau de dopage du canal des transistors ne peut donc pas présenter de variations importantes, ce qui empêche de différencier les tensions de seuil par ce biais. Une solution proposée dans certaines études pour réaliser des transistors de même type à tensions de seuil distinctes est d'intégrer différents matériaux de grille pour ces transistors. Cependant, la réalisation pratique d'un tel circuit intégré s'avère techniquement délicate et économiquement prohibitive.

Afin de disposer de tensions de seuil distinctes pour différents transistors en technologie FDSOI, il est également connu d'utiliser un plan de masse polarisé disposé entre une couche d'oxyde isolante mince (TBOX ou UTBOX) et le substrat de silicium. En jouant sur le dopage des plans de masse et sur leur polarisation, on peut définir une gamme de tensions de seuil pour les différents transistors. On pourra ainsi disposer de transistors à faible tension de seuil dits LVT, de transistors à haute tension de seuil dits HVT et de transistors à tension de seuil moyenne dits SVT.

Pour permettre le fonctionnement des différents transistors, il est nécessaire de les isoler électriquement les uns des autres. Par conséquent, les transistors sont généralement entourés par des tranchées d'isolation (désignées par l'acronyme STI pour Shallow Trench Isolation en langue anglaise) qui s'étendent jusqu'aux caissons.

Dans un certain nombre de configurations de circuits intégrés, il est nécessaire de disposer de tranchées d'isolation additionnelles présentant une profondeur inférieure à la profondeur des tranchées d'isolation précitées.

Ainsi, il est proposé d'utiliser des tranchées d'isolation moins profondes pour réaliser la polarisation des plans de masse par l'intermédiaire de prises de contact latérales. Les processus de fabrication envisagés introduisant des risques d'altération de la couche UTBOX (grande sensibilité de cette couche du fait de sa faible épaisseur), des tranchées d'isolation moins profondes peuvent également être utilisées pour réaliser une protection latérale de la couche UTBOX, pour ainsi éviter un risque de court-circuit entre le transistor et le substrat. Ces tranchées d'isolation moins profondes traversent la couche UTBOX ne s'étendent pas jusqu'à la profondeur de l'interface entre les plans de masse et les caissons. La formation de tranchées d'isolation présentant deux profondeurs distinctes s'avère en pratique problématique. En effet, une telle structure nécessite potentiellement des procédés de fabrication nettement plus complexes ou différant fortement par rapport à des procédés de fabrication éprouvés.

Le document US2008/0157404 décrit un procédé de fabrication d'un circuit intégré sur SOI, et notamment la fabrication de repères d'alignement en vue d'opérations de lithographie électronique. Ce document décrit la formation de motifs d'alignement et de tranchées d'isolation remplies de matériau isolant et formées dans des étapes différentes.

Le document US2007/0063284 décrit un transistor FDSOI. Ce document ne décrit cependant pas le procédé de fabrication de ce transistor. Ce transistor présentent des tranchées d'isolation de profondeurs distinctes formées à partir de matériau électriquement isolant.

Le document XP002609609, intitulé 'FDSOI CMOS with dielectrically-isolated back gates and 30nm Lg High-[kappa]/Metal Gate' article de Khater et alias, concerne un transistor de technologie FDSOI. Le transistor décrit comporte des première et deuxième tranchées d'isolation s'étendant jusqu'à une couche d'oxyde enterrée, sans atteindre le substrat de silicium.

Par ailleurs, le document US2011 /0057287 décrit un circuit intégré réalisé en technologie Bulk. Ce document propose d'intégrer des cellules mémoires et des circuits périphériques dans deux zones distinctes. Les tranchées d'isolation présentent des profondeurs distinctes dans ces deux zones.

Le procédé de fabrication proposé dans ce document est le suivant. Un film d'oxyde de silicium inférieur est formé par oxydation thermique sur un substrat de silicium. Un film de polysilicium est formé sur le film d'oxyde de silicium inférieur, par un procédé CVD. Un film de nitrure de silicium est formé sur le film de polysilicium par exemple par CVD. Ce film de nitrure de silicium est recouvert d'un film d'oxyde de silicium supérieur. Un masque de photolithographie est réalisé, puis une gravure ou attaque chimique anisotrope est réalisée avec ce masque pour former des tranchées à travers les différents films, jusqu'à une première profondeur dans le substrat de silicium.

Un masque de photolithographie est réalisé et recouvre les tranchées destinées à la zone des cellules mémoires et découvre les tranchées destinées à la zone des circuits périphériques. Ce masque et le film d'oxyde de silicium supérieur servent de masques pour une gravure anisotrope, de sorte que les tranchées destinées à la zone de circuits périphériques sont creusées davantage, et sont donc plus profondes que les tranchées masquées. Le masque est ensuite retiré de façon à découvrir les tranchées les moins profondes. On réalise un dépôt d'oxyde de silicium de façon à remplir les différentes tranchées, par exemple par un procédé de CVD plasma. Ensuite, on réalise le retrait de ce dépôt d'oxyde de silicium en surface, ainsi que le retrait du film d'oxyde de silicium supérieur par un procédé CMP. Par exemple au moyen d'une gravure humide à l'acide orthophosphorique puis hydrofluorique, on réalise le retrait du film de nitrure de silicium, du film de polysilicium et du film d'oxyde de silicium inférieur jusqu'à atteindre le substrat de silicium. On dispose alors de tranchées d'isolation de profondeurs différentes formées par un remplissage d'oxyde de silicium. Un processus usuel de type Bulk est poursuivi pour former les transistors dans la zone de cellules mémoires et dans la zone des circuits périphériques.

La formation de tranchées d'isolation avec deux profondeurs distinctes nécessite des étapes additionnelles ayant un impact non négligeable sur le coût de fabrication d'un tel circuit intégré. Par ailleurs, l'élimination du masque de photogravure dans les tranchées d'isolation les moins profondes est problématique avec les procédés disponibles au-delà d'une certaine valeur de profondeur. En outre, l'adaptation d'un tel procédé à la fabrication de circuits intégrés de type SOI est difficilement envisageable, du fait des risques de détérioration de la couche UTBOX très fine ou des risques de détérioration de la partie supérieure des tranchées d'isolation lors de la formation des transistors dans la couche active ou lors de l'implantation de caissons ou de plans de masse, en particulier lors d'étapes de gravure à l'acide hydrofluorique.

L'invention vise à résoudre un ou plusieurs de ces inconvénients. L'invention porte ainsi sur un procédé de fabrication d'un circuit intégré tel que défini dans la revendication 1 et ses revendications dépendantes.

L'invention porte également sur un circuit intégré tel que défini dans des revendications annexées.

D'autres caractéristiques et avantages de l'invention ressortiront clairement de la description qui en est faite ci-après, à titre indicatif et nullement limitatif, en référence aux dessins annexés, dans lesquels :
- les figures 1 à 8 sont des vues en coupe d'un substrat illustrant différentes étapes d'un exemple de procédé de fabrication d'un circuit intégré selon l'invention ;
- la figure 9 est une vue en coupe d'un substrat à l'issue de la formation d'un transistor ;
- la figure 10 est un logigramme détaillant une suite d'étapes mises en oeuvre dans un exemple de procédé de fabrication selon l'invention
- la figure 11 est une vue en coupe d'un substrat illustrant une étape d'un procédé de fabrication selon une variante selon l'invention ;
- la figure 12 est une vue en coupe d'un substrat illustrant une étape d'un procédé de fabrication selon une autre variante selon l'invention ;
- la figure 13 est une vue en coupe d'un substrat illustrant une étape d'encore une autre variante selon l'invention.

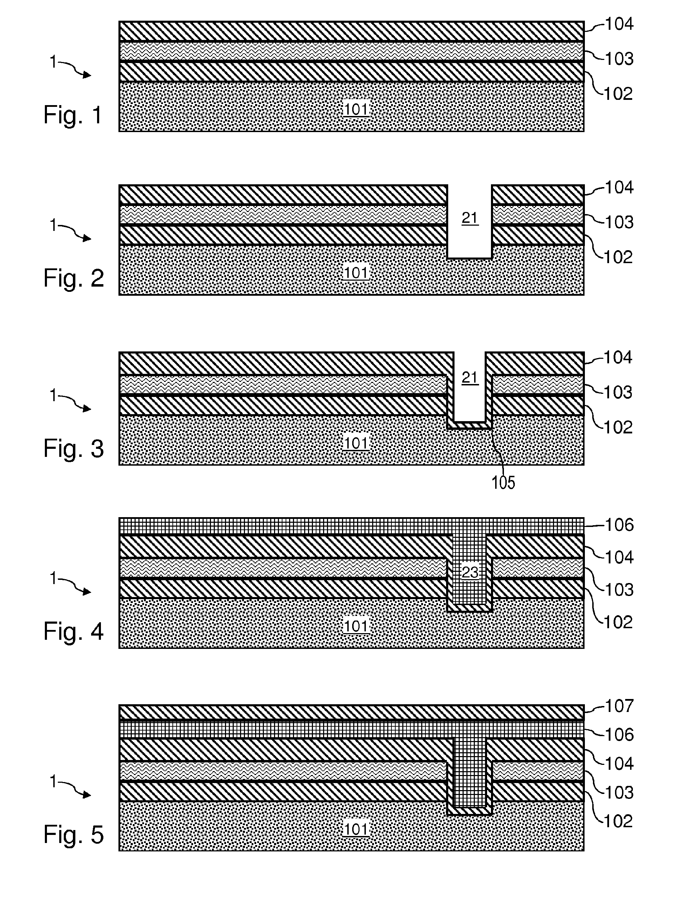

Les figures 1 à 8 sont des vues en coupe d'un substrat illustrant différentes étapes d'un procédé de fabrication d'un circuit intégré selon un exemple de mise en oeuvre de l'invention.

À la figure 1, on dispose d'un substrat de silicium 101, présentant typiquement un dopage de type P. Le substrat 101 est surplombé par une couche d'isolant enterré 102, typiquement en oxyde de silicium. La couche d'isolant enterré 102 est surplombée par une couche active de silicium 103, dans laquelle on souhaite former la source, le drain et le canal de différents transistors. Dans cet exemple, la couche active de silicium 103 est surplombée par une couche d'isolant 104, typiquement en oxyde de silicium.

On réalise ensuite une étape de gravure de premières gorges 21 jusqu'au substrat de silicium 101, pour aboutir à la structure illustrée à la figure 2. Cette gravure est réalisée jusqu'à une profondeur pouvant par exemple être comprise entre 10 et 100 nm sous la couche d'isolant enterré 102. Cette gravure peut typiquement être une gravure anisotrope. Cette gravure peut être réalisée de façon connue en formant au préalable des masques de résine photorésistive avec des motifs appropriés et en appliquant une étape de gravure au plasma. La couche d'isolant 104 en oxyde de silicium participe à la protection des couches inférieures avec le masque de résine, lors de l'étape de gravure.

Dans cet exemple, on réalise avantageusement (mais pas obligatoirement) un dépôt d'isolant en pleine plaque, pour aboutir à la structure illustrée à la figure 3. Ce dépôt d'isolant forme une couche 105 recouvrant la couche 104, les parois latérales de la gorge 21 et le fond de la gorge 21. Cette couche 105 peut par exemple présenter une épaisseur comprise entre 1 et 4 nm, de préférence entre 2 et 3 nm. Ce dépôt d'isolant est réalisé de façon à ne pas remplir la partie médiane de la gorge 21. La couche 105 est avantageusement réalisée en oxyde de silicium, afin de présenter une structure homogène avec la couche 104 et afin de faciliter le processus de fabrication. La formation de l'oxyde de silicium peut être réalisée de façon connue en soi par exemple par un procédé CVD. La gorge 21 est avantageusement réalisée avec une largeur au moins égale à 40nm pour un noeud technologique en 20nm.

On réalise ensuite une étape de dépôt d'une couche de nitrure de silicium 106 surplombant la couche active de silicium 103 et la couche d'isolant 104. Le dépôt du nitrure de silicium est réalisé de façon à remplir la gorge 21, pour aboutir à la structure illustrée à la figure 4, pourvue d'une première tranchée d'isolation 23. Le dépôt de la couche 106 de nitrure de silicium peut être réalisé par un procédé CVD. Le dépôt de la couche 106 de nitrure de silicium peut être réalisé pour former du nitrure de silicium contraint. La couche 106 pourra par exemple présenter une épaisseur typiquement comprise entre 50 et 100 nm en surface.

On réalise ensuite avantageusement le dépôt d'une couche d'oxyde de silicium 107 surplombant la couche 106 de nitrure de silicium, pour aboutir à la structure illustrée à la figure 5.

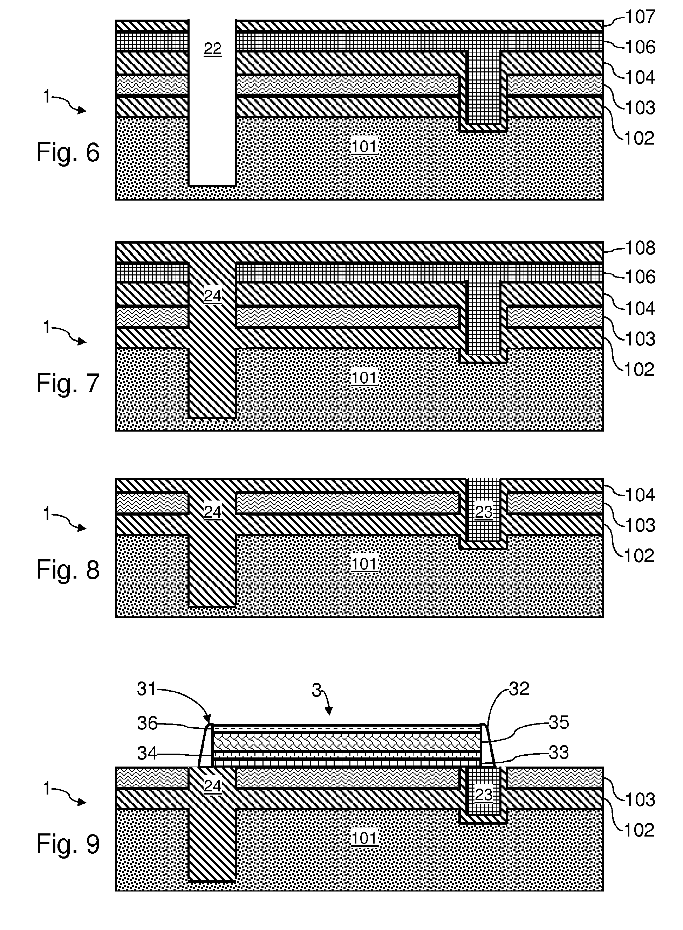

On réalise ensuite une étape de gravure de deuxièmes gorges 22 jusqu'au substrat de silicium 101, pour aboutir à la structure illustrée à la figure 6. Cette gravure est réalisée jusqu'à une profondeur pouvant par exemple être comprise entre 30 et 300 nm sous la couche d'isolant enterré 102. Afin de disposer de tranchées d'isolation présentant différentes profondeurs, les gorges 22 sont gravées jusqu'à une profondeur supérieure à la profondeur des gorges 21. Cette gravure peut typiquement être une gravure anisotrope. Cette gravure peut être réalisée de façon connue en formant au préalable des masques de résine photorésistive avec des motifs appropriés et en appliquant une étape de gravure au plasma. La gorge 22 est avantageusement réalisée avec une largeur au moins égale à 40nm pour un noeud technologique en 20nm. La couche d'oxyde de silicium 107 participe à la protection des couches inférieures avec le masque de résine, lors de cette étape de gravure. La couche de nitrure de silicium 106, utilisée comme matériau de remplissage des gorges 21, participe également à la protection des couches inférieures avec le masque de résine, lors de cette étape de gravure. On procède ensuite au retrait du masque de résine, et le cas échéant au retrait de tout ou partie de la couche d'oxyde de silicium 107. À la figure 6, une partie de la couche d'oxyde de silicium 107 a été retirée avec le masque de résine.

On réalise ensuite une étape de remplissage de la gorge 22 par un matériau isolant électrique, pour aboutir à la structure illustrée à la figure 7, munie d'une seconde tranchée d'isolation 24. L'étape de remplissage est ici réalisée par la formation d'une couche d'oxyde de silicium 108. La couche d'oxyde de silicium 108 formée est ici montrée confondue avec la couche d'oxyde de silicium 107 résiduelle.

On réalise ensuite une étape de retrait des couches 106, 107 et 108, jusqu'à découvrir la couche d'oxyde de silicium 104, pour aboutir à la structure illustrée à la figure 8. Cette étape de retrait peut être réalisée de façon connue en soi par la combinaison d'un processus CMP (pour Chemical Mechanical Polishing en langue anglaise) et d'un processus de gravure humide (par exemple à l'acide fluorhydrique).

On constate que les étapes illustrées aux figures 5 à 8 sont une succession d'étapes usuelles d'un processus de formation d'une tranchée d'isolation en technologie Bulk. Par conséquent, le procédé de fabrication d'un circuit intégré à double profondeur de tranchées et en technologie SOI selon l'invention peut aisément être mis en oeuvre sur la base d'étapes technologiques parfaitement maîtrisées.

Un tel procédé permet d'aboutir à des tranchées d'isolation 23 et 24 présentant des profondeurs différentes et incorporant des matériaux différents, au moins dans leur partie médiane, sans pour autant complexifier le procédé de fabrication. On peut noter que le matériau de la partie médiane des tranchées d'isolation 23 est du nitrure de silicium, matériau usuellement utilisé pour protéger les couches inférieures lors de la gravure d'une gorge. La résistance des tranchées d'isolation 23 aux étapes ultérieures du procédé de fabrication (telle que les étapes de nettoyage utilisant de l'acide fluorhydrique) est ainsi accrue, ce qui permet d'éliminer des risques de dysfonctionnement suite à d'éventuelles détériorations par érosion lors de ces étapes ultérieures.

Le nitrure de silicium est ici utilisé à la fois pour remplir les gorges 21, et pour protéger les couches inférieures lors de la gravure des gorges 22, lors du remplissage des gorges 22, ou lors d'étapes CMP, ce qui permet d'obtenir des tranchées d'isolation 23 moins profondes mais tout de même plus résistantes pour la suite du procédé de fabrication, sans induire d'importants surcoûts de ce procédé de fabrication. Cette résistance des tranchées d'isolation 23 permet notamment d'assurer une bonne protection d'une couche UTBOX 102, dont la faible épaisseur la rend particulièrement sensible à toute détérioration.

La formation de la couche d'oxyde 105 sur les parois de la gorge 21 permet d'éviter d'éventuels problèmes d'interface entre le nitrure de silicium et le substrat 101, la couche UTBOX 102 ou la couche active 103. La couche 105 permet notamment d'éviter de piéger des charges électriques au niveau de ces interfaces avec la tranchée d'isolation 24.

Lors d'étapes ultérieures connues en soi, on réalise des transistors à effet de champ, dont la source, le drain et le canal sont formés dans la couche active de silicium 103. Un exemple de structure à l'issue de ces étapes est illustré à la figure 9. Ces transistors peuvent être de type FDSOI et peuvent comporter une grille arrière polarisée.

Un transistor 3 est illustré ici. Le transistor 3 comporte un empilement de grille 31. L'empilement de grille 31 comporte un oxyde de grille 33 recouvrant le canal du transistor 3. L'oxyde de grille 33 est surmonté par une couche métallique 34. La couche métallique 34 est surmontée par une couche de polysilicium 35. La couche de polysilicium 35 est avantageusement surmontée par une couche de protection en nitrure de silicium 36. Les empilements 31 sont délimités latéralement par des espaceurs 32. Les tranchées d'isolation 23 et 24 sont placées à la périphérie du transistor 3. La structure et le procédé de formation des empilements 31 du transistor 3 étant connus en soi, ceux-ci ne seront pas davantage décrits.

Dans un souci de simplification, le plan de masse, sa prise de polarisation et l'éventuel caisson dans lequel ce plan de masse est implanté, ne sont pas illustrés pour le transistor 3 illustré à la figure 9. Afin de permettre une modulation de la tension de seuil du transistor 3 en jouant sur la polarisation et le dopage de son plan de masse, la couche d'isolant 102 enterrée est du type UTBOX, ce type de couche présentant typiquement une épaisseur comprise entre 10 et 50 nm.

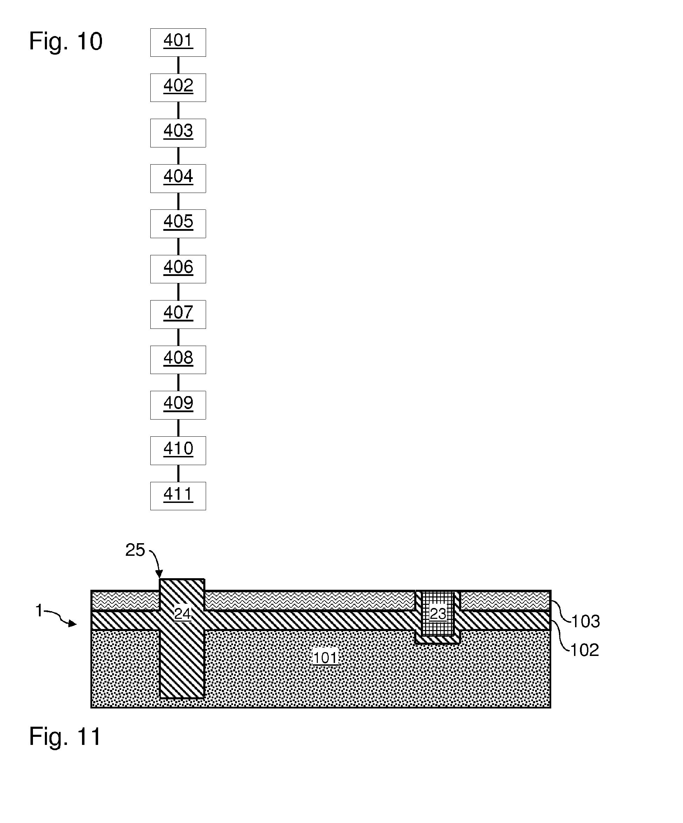

La figure 10 est un logigramme récapitulant l'ensemble des étapes mises en oeuvre dans l'exemple du procédé décrit ci-dessus.

Lors de l'étape 401, on récupère le substrat de silicium 101, surplombé de la couche d'isolant enterré 102, surplombée de la couche active de silicium 103, elle-même surplombée par la couche d'oxyde de silicium 104.

Lors de l'étape 402, on réalise l'étape de gravure des premières gorges 21 jusqu'au substrat de silicium 101.

Lors de l'étape 403, on réalise le dépôt de la couche d'oxyde de silicium 105.

Lors de l'étape 404, on dépose la couche de nitrure de silicium 106 de façon à remplir les premières gorges 21.

Lors de l'étape 405, on dépose la couche d'oxyde de silicium 107 surplombant la couche de nitrure de silicium 106.

Lors de l'étape 406, on réalise un masque de gravure avec une couche de résine photorésistive.

Lors de l'étape 407, on réalise la gravure des deuxièmes gorges 22 jusqu'au substrat de silicium 101.

Lors de l'étape 408, on retire le masque de résine photorésistive.

Lors de l'étape 409, on remplit les secondes gorges 22 lors de la formation d'une couche d'oxyde de silicium 108.

Lors de l'étape 410, on procède au retrait des couches 106,107 et 108 jusqu'à découvrir la couche d'oxyde de silicium 104.

Lors de l'étape 411, on procède à la formation de transistors sur le substrat obtenu précédemment.

L'étape 410 inclut le retrait des couches d'oxyde de silicium 107 et 108 et de nitrure de silicium 106. Du fait de l'utilisation de matériaux différents pour le remplissage de la partie médiane des tranchées d'isolation 23 et 24, il peut s'avérer utile de disposer d'une tranchée d'isolation 24 saillante vers le haut par rapport à la tranchée d'isolation 23 ou réciproquement, à l'issue du retrait de la couche de nitrure de silicium 106. Lors de l'étape 410, une étape de gravure humide ou sèche du nitrure de silicium peut par exemple être mise en oeuvre de sorte que les tranchées d'isolation 24 soient plus hautes que les tranchées d'isolation 23, comme illustré à la figure 11, à l'issue du retrait de la couche d'oxyde de silicium 104. Ainsi, la surépaisseur 25 de la tranchée d'isolation 24 permet de tenir compte d'un plus grand risque d'altération de l'oxyde de silicium par rapport au nitrure de silicium lors d'une éventuelle étape ultérieure de gravure avec de l'acide fluorhydrique. On pourra par exemple envisager de maintenir une surépaisseur 25 comprise entre 10 et 50nm pour la tranchée d'isolation 24 à l'issue de l'étape de gravure humide ou sèche d'une partie du nitrure 23.

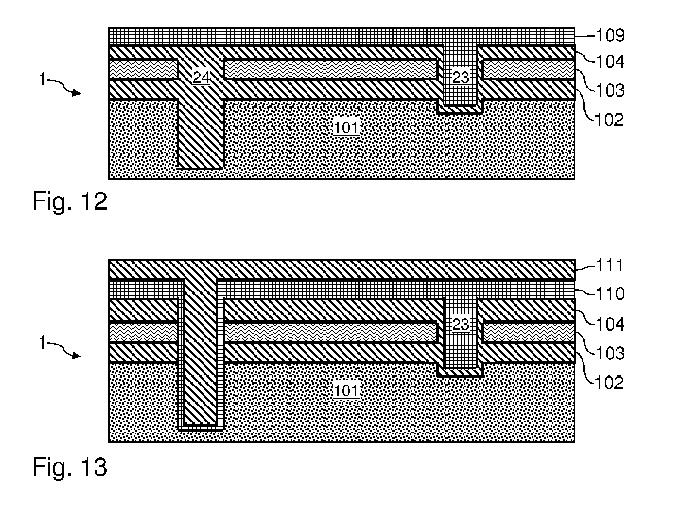

La figure 12 est une vue en coupe d'un substrat illustrant une étape d'une variante du procédé de fabrication selon l'invention. Suite au retrait des couches 106, 107 et 108 permettant de découvrir la couche d'oxyde de silicium 104 comme illustré à la figure 8, il peut s'avérer intéressant de mettre en oeuvre une étape additionnelle de dépôt d'une couche de nitrure de silicium 109 à l'aplomb de la couche d'oxyde de silicium 104. Cette variante s'avère utile lorsque des étapes ultérieures mettent en oeuvre une croissance par épitaxie d'une couche de Silicium-Germanium.

La figure 13 est une vue en coupe d'un substrat illustrant une étape d'une autre variante du procédé de fabrication selon l'invention. Selon ce procédé, postérieurement au dépôt de la couche d'oxyde de silicium 107 surplombant la couche 106 de nitrure de silicium, on procède au retrait de la couche 107 et de la couche 106 jusqu'à découvrir la couche d'oxyde de silicium 104. On procède alors à la gravure de la gorge 22 jusqu'à atteindre le substrat de silicium 101. On réalise ensuite le dépôt d'une couche de nitrure de silicium 110 surplombant cette couche d'oxyde de silicium 104, de façon à recouvrir les parois latérales et le fond de la gorge 22. La couche de nitrure de silicium 110 déposée est suffisamment fine pour ne pas remplir la partie médiane de la gorge 22. On procède ensuite au dépôt d'une couche d'oxyde de silicium 111 de façon à remplir la partie médiane de la gorge 22, et ainsi former la tranchée d'isolation 24. La tranchée d'isolation 24 ainsi formée permet de résoudre certains problèmes spécifiques d'isolation en profondeur pour des cellules mémoire. Le procédé peut se poursuivre à l'étape 410 en procédant au retrait des couches 110 et 111 au lieu des couches 108, 107 et 106.

## Revendications

1. Procédé de fabrication d'un circuit intégré, **caractérisé en ce qu'il** comprend les étapes de :
- dans un empilement de couches incluant un substrat de silicium (101) surplombé par une couche d'isolant enterré (102) surplombée par une couche de silicium (103), graver des premières gorges jusqu'au substrat de silicium ;
- déposer une couche de nitrure de silicium (106) surplombant la couche de silicium de façon à remplir lesdites premières gorges et former des premières tranchées d'isolation;
- former un masque surplombant la couche de nitrure de silicium ;
- graver des secondes gorges (22) jusqu'au substrat de silicium selon le motif défini par le masque, à une profondeur supérieure à la profondeur des premières gorges;
- remplir les secondes gorges par un matériau isolant électrique pour former des deuxièmes tranchées d'isolation;
- réaliser une attaque chimique jusqu'à découvrir la couche de silicium (103) ;
- former des transistors FET en formant le canal, la source et le drain de ces transistors dans la couche de silicium (103).

2. Procédé de fabrication d'un circuit intégré selon la revendication 1, dans lequel ladite couche d'isolant enterré (102) surplombée par la couche de silicium (103) présente une épaisseur comprise entre 10 et 50 nm.

3. Procédé de fabrication d'un circuit intégré selon la revendication 1 ou 2, dans lequel ladite couche d'isolant enterré (102) est en oxyde de silicium.

4. Procédé de fabrication selon l'une quelconque des revendications précédentes, dans lequel ladite gravure des premières gorges (21) est réalisée jusqu'à une profondeur comprise entre 10 et 100 nm sous la couche d'isolant enterré (102).

5. Procédé de fabrication selon l'une quelconque des revendications précédentes, dans lequel l'étape de dépôt d'une couche de nitrure de silicium est précédée d'une étape de dépôt d'une couche d'oxyde de silicium (105) sur les parois des premières gorges (21) de façon à ménager un vide dans la partie médiane de ces premières gorges.

6. Procédé de fabrication selon la revendication 5, dans lequel l'épaisseur de la couche d'oxyde de silicium (105) déposée sur les parois des premières gorges (21) est comprise entre 1 et 4 nm.

7. Procédé de fabrication selon l'une quelconque des revendications précédentes, dans lequel ledit matériau isolant électrique de remplissage des secondes gorges n'est pas du nitrure de silicium.

8. Procédé de fabrication selon la revendication 7, dans lequel ledit matériau isolant électrique de remplissage des secondes gorges (22) est de l'oxyde de silicium.

9. Procédé de fabrication selon la revendication 7 ou 8, dans lequel ladite attaque chimique inclut une gravure réalisée de sorte que l'oxyde de remplissage des secondes gorges (22) forme une surépaisseur (25) par rapport à la surface de la couche de silicium et par rapport au sommet des premières tranchées d'isolation (23).

10. Procédé de fabrication selon l'une quelconque des revendications précédentes, dans lequel l'empilement de couches, sur lequel la couche de nitrure de silicium (106) est déposée, inclut une couche d'oxyde de silicium (104) surplombant la couche de silicium (103).

11. Procédé de fabrication selon l'une quelconque des revendications précédentes, dans lequel l'étape de formation d'un transistor FET (3) inclut :
- l'implantation d'un caisson sous la couche d'isolant enterré (102) ;
- l'implantation d'un plan de masse entre le caisson et la couche d'isolant enterré ;
- la formation du canal, de la source et du drain du transistor dans la couche de silicium (103) à l'aplomb du caisson et du plan de masse implantés.

12. Procédé de fabrication selon l'une quelconque des revendications précédentes, dans lequel lesdites étapes de gravure des gorges sont précédées de polissages mécano chimiques.

13. Circuit intégré, **caractérisé en ce qu'il** comprend :
- un empilement de couches incluant un substrat de silicium (101) surplombé par une couche d'isolant enterré (102) surplombée par une couche de silicium (103) ;
- des transistors FET dont le canal, la source et le drain sont formés dans la couche de silicium (103) ;
- des premières tranchées d'isolation (23) disposées à la périphérie des transistors, s'étendant jusqu'au substrat de silicium et remplies de nitrure de silicium ;
- des deuxièmes tranchées d'isolation (24) disposées à la périphérie des transistors, s'étendant jusqu'au substrat de silicium à une profondeur supérieure à la profondeur des premières tranchées d'isolation, ces deuxièmes tranchées d'isolation étant remplies d'un matériau isolant électrique différent du nitrure de silicium.

14. Circuit intégré selon la revendication 13, comprenant :
- des caissons ménagés dans le substrat à l'aplomb des transistors FET ;
- des plans de masse ménagés à l'aplomb des transistors FET entre la couche d'isolant enterré et les caissons, lesdites premières tranchées d'isolation ne s'étendant pas en profondeur jusqu'à l'interface entre les caissons et les plans de masse.
